(19) Europäisches Patentamt
European Patent Office
Office européen des brevets

(11) **EP 2 405 029 A1**

(12) **EUROPÄISCHE PATENTANMELDUNG**

(43) Veröffentlichungstag:
**11.01.2012 Patentblatt 2012/02**

(51) Int Cl.:
***C23C 14/58*** *(2006.01)*     ***C23C 14/06*** *(2006.01)*
***F01D 5/28*** *(2006.01)*

(21) Anmeldenummer: **10168291.2**

(22) Anmeldetag: **02.07.2010**

(84) Benannte Vertragsstaaten:
**AL AT BE BG CH CY CZ DE DK EE ES FI FR GB GR HR HU IE IS IT LI LT LU LV MC MK MT NL NO PL PT RO SE SI SK SM TR**
Benannte Erstreckungsstaaten:
**BA ME RS**

(71) Anmelder: **Brandenburgische Technische Universität Cottbus**
**03046 Cottbus (DE)**

(72) Erfinder:
- **Schroeter, Olaf**
  **09661, Hainichen (DE)**

- **Maier, Alexander**
  **03042, Cottbus (DE)**
- **Flores Renteria, Arturo**
  **10715, Berlin (DE)**
- **Leyens, Christoph**
  **53639, Königswinter (DE)**

(74) Vertreter: **Gulde Hengelhaupt Ziebig & Schneider**
**Patentanwälte - Rechtsanwälte**
**Wallstrasse 58/59**
**10179 Berlin (DE)**

(54) **Verfahren zur Herstellung einer haft- und kratzfesten Schutzschicht auf einem metallischen Werkstück**

(57) Die Erfindung betrifft ein Verfahren zur Herstellung einer haft- und kratzfesten Schutzschicht auf einem metallischen Werkstück, wobei die Schutzschicht ein örtlich angepasstes Erosionsverhalten besitzt. Das Verfahren umfasst die folgenden Schritte:

a) Bereitstellen eines metallischen Werkstücks aus einer Legierung auf Basis von Nickel, Eisen, Titan, Aluminium, Magnesium, Zink oder Kupfer;

b) Beschichten des Werkstücks mit einer MAX-Phase der Formel (1)

$$M_{n+1}AX_n \qquad (1)$$

mit

$M$ = Ti, Cr, V, Nb oder Mo;
$A$ = Ga, Al, Ge oder Si;
$X$ = C oder N; sowie
$n$ = 1, 2 oder 3; und

c) örtlich differenzierte Wärmebehandlung des beschichteten Werkstücks, derart, dass

i) das Werkstück in einem ersten Bereich auf eine Temperatur aufgeheizt wird, die oberhalb einer Temperatur $T_{diff}$ liegt, ab der sich eine Diffusionszone zwischen der MAX-Phase und der Legierung des Werkstücks ausbildet, die jedoch unterhalb einer Temperatur $T_{um}$ liegt, ab der sich die MAX-Phase in eine keramische Phase umwandelt; und

ii) das Werkstück in einem zweiten Bereich auf eine Temperatur aufgeheizt wird, die oberhalb der Temperatur $T_{um}$ liegt, ab der sich die MAX-Phase in eine keramische Phase umwandelt.

EP 2 405 029 A1

**Beschreibung**

Die Erfindung betrifft ein Verfahren zur Herstellung einer haft- und kratzfesten Schutzschicht auf einem metallischen Werkstück, wobei die Schutzschicht ein örtlich angepasstes Erosionsverhalten besitzt.

**Stand der Technik und Hintergrund der Erfindung**

Massenverluste auf Grund von mechanischer Erosion können an Festkörpern sowohl in flüssigen als auch in gasförmigen Medien auftreten. Die Größe des Massenverlustes wird davon beeinflusst, ob sich in dem strömenden Medium bewegte Teilchen, das heißt feste oder flüssige Partikel, befinden. Die Verknüpfung verschiedener Randbedingungen führt zu unterschiedlichen Verschleißarten, die in thermische Erosion, Spülverschleiß, Tropfenschlag oder Strahlverschleiß aufgeteilt werden. Die für die vorliegende Erfindung wesentliche Verschleißart ist der Strahlverschleiß, bei dem in einem Gasstrom befindliche Abrasivstoffe auf einen festen Körper wirken. Bei diesem Vorgang handelt es sich demnach um einen Stoßprozess zwischen den Abrasivpartikeln und dem Festkörper.

Verschiedene Parameter beeinflussen den Massenverlust durch Strahlverschleiß, unter anderem das Verhältnis von Partikel- und Werkstoffhärte, die Partikelgröße, die Auftreffgeschwindigkeit des Partikels als auch der Aufprallwinkel. Die Strahlverschleißbeanspruchung kann in der Praxis grundsätzlich im gesamten Winkelbereich von 0 bis 90 ° auftreten. Es finden in Abhängigkeit vom Aufprallwinkel jedoch völlig unterschiedliche Abtragungsprozesse statt.

Bei flachen Anstrahlwinkeln erfolgt der Werkstoffabtrag nach einem Mikrozerspanungsprozess (Furchungsverschleiß), bei großen Winkeln ist der Mechanismus der Werkstoffzerrüttung (Stoßprozesse) immer dominierend. Dazwischen erfolgt der Materialverlust durch Schrägstrahlverschleiß. In diesem Fall tragen beide oben erwähnten Mechanismen in Abhängigkeit vom Auftreffwinkel zum Materialverlust bei.

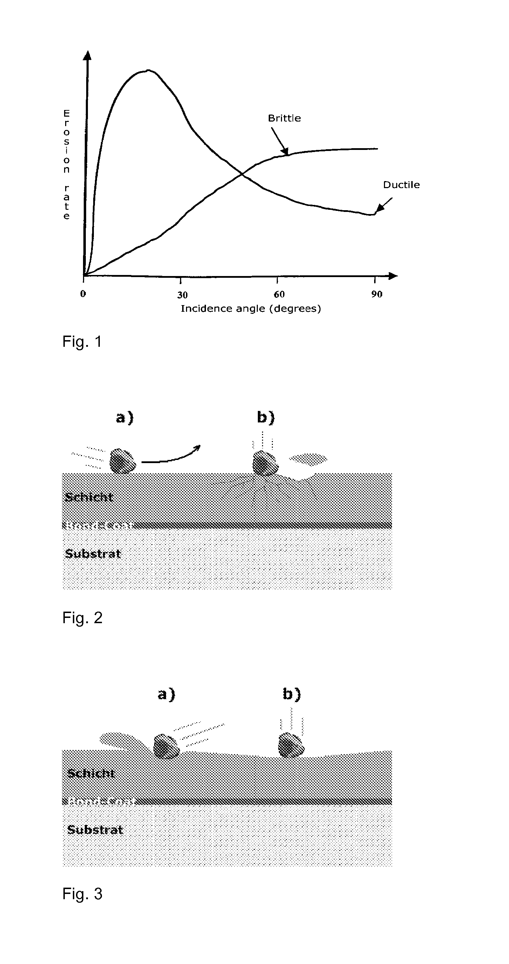

Durch Auftragung einer haft- und kratzfesten Schutzschicht versucht man die mechanische Erosion, insbesondere durch Strahlverschleiß, zu minimieren. Das zur Herstellung der Schutzschicht verwendete Material kann dabei entweder als spröde (keramisch) oder duktil (metallisch) charakterisiert werden. Diese Materialbeschaffenheit beeinflusst jedoch auch erheblich die mechanische Erosion in Abhängigkeit zum Aufprallwinkel. Bei kleinen Aufprallwinkeln der Erosionspartikel ist ein keramisches Material erosionsbeständiger und bei großen Winkeln eine metallische Oberfläche. **Figur 1** illustriert die Erosionsrate in Abhängigkeit des Aufprallwinkels des Erosionsmittels auf spröde (brittle) und verformbare (ductile) Oberflächen.

Der Grund für das Verhalten bei keramischen Materialien ist, dass bei flachen Winkeln die Partikel reflektieren, während bei senkrechtem Aufprallwinkel das Material Risse bildet und abplatzt (**Figur 2**). Bei metallischen Materialien wird beim streifenden Einfall das Material abgeschert und bei senkrechtem Auftreffen verformt, ohne Material abzutragen (**Figur 3**). In der Praxis werden daher Multilagenschichten als Erosionsschutzschichten eingesetzt, die aus einem Wechsel von Einzellagenschichten aus Keramiken und Metallen bestehen. Die Herstellung derartiger Schichten ist verfahrenstechnisch relativ aufwendig und damit kostspielig. Weiterhin ist die Erosionsrate bei flachen Aufprallwinkeln deutlich schlechter als bei rein keramischen Schichten und bei nahezu senkrechten Aufprallwinkeln schlechter als bei rein metallischen Schutzschichten. Gründe hierfür können beispielsweise die schlechte Haftung zwischen den einzelnen Lagen der Multilagenbeschichtung sein. Insbesondere wenn das Werkstück in verschiedenen Bereichen einem Strahlverschleiß unter unterschiedlichen Aufprallwinkeln ausgesetzt ist, kann die mechanische Erosion schnell die für die jeweilige Applikation festgelegte Toleranz überschreiten.

Alternativ könnten bei Werkstücken, die einem Strahlverschleiß in verschiedenen Bereichen unter unterschiedlichen Aufprallwinkeln ausgesetzt sind, jeweils Schutzschichten mit örtlich angepassten Erosionsverhalten aufgebracht werden. Das heißt, in Bereichen, wo mit flachen Aufprallwinkeln zu rechnen ist, wird eine keramische Schutzschicht aufgetragen, während in Bereichen, in denen der Aufprallwinkel nahezu 90 ° beträgt, metallische Schutzschichten vorgesehen sind. Gerade bei Werkstücken mit komplexer Geometrie ist die sukzessive Auftragung metallischer und keramischer Schichten jedoch erschwert, abgesehen davon, dass eine solche Prozessierung separate Bearbeitungsschritte zwingend erforderlich macht.

**Zusammenfassung der Erfindung**

Ein Aspekt der Erfindung liegt in der Bereitstellung eines neuartigen Verfahrens zur Herstellung einer haft- und kratzfesten Schutzschicht auf einem metallischen Werkstück, wobei die Schutzschicht ein örtlich angepasstes Erosionsverhalten besitzt. Das Verfahren, das eines oder mehrere der zuvor angesprochenen Probleme löst oder zumindest mindert, umfasst die folgenden Schritte:

> a) Bereitstellen eines metallischen Werkstücks aus einer Legierung auf Basis von Nickel, Eisen, Titan, Aluminium, Magnesium, Zink oder Kupfer;
> b) Beschichten des Werkstücks mit einer MAX-Phase der Formel (1)

$$M_{n+1}AX_n \qquad (1)$$

mit

M = Ti, Cr, V, Nb oder Mo;

A = Ga, Al, Ge oder Si;

X = C oder N; sowie

n = 1, 2 oder 3; und

c) örtlich differenzierte Wärmebehandlung des beschichteten Werkstücks, derart, dass

> i) das Werkstück in einem ersten Bereich auf eine Temperatur aufgeheizt wird, die oberhalb einer Temperatur $T_{diff}$ liegt, ab der sich eine Diffusionszone zwischen der MAX-Phase und der Legierung des Werkstücks ausbildet, die jedoch unterhalb einer Temperatur $T_{um}$ liegt, ab der sich die MAX-Phase in eine keramische Phase umwandelt; und
>
> ii) das Werkstück in einem zweiten Bereich auf eine Temperatur aufgeheizt wird, die oberhalb der Temperatur $T_{um}$ liegt, ab der sich die MAX-Phase in eine keramische Phase umwandelt.

Der Erfindung liegt die Erkenntnis zugrunde, dass sich eine im Strahlverschleißverhalten bezüglich des Aufprallwinkels differenzierte Erosionsschutzschicht in besonders einfacher Weise schon dadurch erzeugen lässt, dass das Werkstück mit einer MAX-Phase der zuvor genannten Formel (1) beschichtet wird. Eine örtliche Differenzierung hin zu Abschnitten, in denen die Schutzschicht stärkeren keramischen Charakter beziehungsweise stärkeren metallischen Charakter besitzt, erfolgt durch eine differenzierte Wärmebehandlung des beschichteten Werkstücks. Darüber hinaus besitzt die Schutzschicht ein besonders hohes Haftvermögen, was den Erosionswiderstand zusätzlich erhöht.

Die örtlich differenzierte Wärmebehandlung des beschichteten Werkstücks gemäß Schritt c) des Verfahrens sieht demnach in jedem Falle vor, dass zunächst auf eine Temperatur $T_{diff}$ aufgeheizt wird, bei der sich zwischen der aufgetragenen MAX-Phase und der Legierung des Werkstücks eine Diffusionszone ausbildet. Die Diffusionszone ist in der Regel zwischen 0,1 und 15 $\mu$m dick und trägt wesentlich zur verbesserten Haftung der Schutzschicht bei. In Bereichen, in denen flache Aufprallwinkel der Erosionspartikel zu erwarten sind, wird das Werkstück danach auf eine Temperatur $T_{um}$ aufgeheizt, in der sich die aufgetragene MAX-Phase in eine keramische Phase wandelt. In Abhängigkeit von der Temperatur und der Dauer dieser zweiten Wärmebehandlung erfolgt die Umwandlung hin zu einer Schutzschicht mit keramischem Charakter vollständig oder nur partiell. Mit Erreichen der Umwandlungstemperatur $T_{um}$ entstehen aus dem aufgetragenen Material Carbide und Nitride des Metalls M. Die Komponente A wird vermutlich zumindest partiell bei Erreichen der Umwandlungstemperatur $T_{um}$ sublimiert. Die entstehenden Carbide/Nitride sind spröde, besitzen also einen keramischen Charakter.

Der Vorteil des erfindungsgemäßen Verfahrens liegt demnach darin, dass eine örtliche Differenzierung der Erosionsschutzschicht durch eine thermische Wärmebehandlung erfolgen kann, die Auftragung der Schutzschicht auf dem gesamten Werkstück jedoch in einem gemeinsamen Verfahrensschritt erfolgt. Weiterhin ist auch der Übergang zwischen Bereichen mit eher keramischen Charakter und Bereichen mit eher metallischem Charakter fließend, so dass Spannungen zwischen den einzelnen Bereichen der Schutzschicht gering sind. In Abhängigkeit von der Dauer der thermischen Behandlung oberhalb der Umwandlungstemperatur kann schließlich das Ausmaß der Umwandlung der zunächst metallischen MAX-Phase in die keramische Schutzschicht beeinflusst werden. Mit anderen Worten, in Bereichen, in denen dass Werkstück einem Strahlverschleiß unter mittlerem Aufprallwinkel der Erosionspartikel ausgesetzt ist, kann die Schutzschicht Domänen mit teils keramischen und teils metallischen Verhalten aufweisen und so den besonderen Erfordernissen unter diesen Aufprallwinkeln genügen.

Das metallische Werkstück besteht ganz oder zumindest in den zu beschichtenden Bereichen aus einer Legierung auf Basis von Nickel, Eisen, Titan, Aluminium, Magnesium, Zink oder Kupfer. Vorzugsweise besteht das Metallwerkstück jedoch aus einer Titan- oder Nickellegierung. Die erfindungsgemäße Schutzschicht eignet sich für metallische Werkstücke mit komplexer Geometrie, insbesondere Turbinenschaufeln.

Die Beschichtung des Werkstücks im Schritt b) des Verfahrens mit der MAX-Phase erfolgt vorzugsweise über ein PVD-Verfahren.

Vorzugsweise ist die MAX-Phase ausgewählt aus der Gruppe umfassend $Ti_2GaC$, $Ti_2AlC$, $Ti_2AlN$, $Ti_3AlC_2$, $Ti_4AlN_3$, $Ti_2GeC$, $Ti_3GeC_2$, $Ti_3SiC_2$, $Cr_2GaC$, $Cr_2GaN$, $Cr_2AlC$, $Cr_2GeC$, $V_2GaC$, $V_2GaC$, $V_2AlC$, $V_2GeC$, $Nb_2GaC$, $Nb_2AlC$, $Mo_2GaC$ und $Mo_2GaC$. Insbesondere umfasst diese Gruppe $Ti_2AlC$, $Ti_2AlN$, $Ti_3GeC_2$, $Ti_3SiC_2$, $Cr_2AlC$, $V_2AlC$ und $Nb_2AlC$. Besonders bevorzugt ist die MAX-Phase $Cr_2AlC$.

Ein weiterer Aspekt der Erfindung liegt in der Bereitstellung metallischer Werkstücke mit einer haft- und kratzfesten Schutzschicht, die ein örtlich angepasstes Erosionsverhalten besitzt und nach dem zuvor beschriebenen Verfahren hergestellt wurde.

## Kurzbeschreibung der Figuren

Die Erfindung wird nachfolgend anhand von Ausführungsbeispielen und der dazugehörigen Zeichnungen näher erläutert. Es zeigen:

Fig. 1    Zusammenhang der Erosionsrate in Abhängigkeit vom Aufprallwinkel des Erosionsmittels auf spröde und duktile Oberflächen;

Fig. 2    Schadensmechanismus bei einer keramischen Schicht in Abhängigkeit vom Aufprallwinkel;

Fig. 3 Schadensmechanismus bei einer metallischen Schutzschicht in Abhängigkeit vom Aufprallwinkel;

Fig. 4 Illustration des Funktionsprinzips der Wärmebehandlung zur Herstellung der Diffusionszone;

Fig. 5 Illustration des Funktionsprinzips der Wärmebehandlung mit örtlich selektiver Umwandlung der aufgebrachten MAX-Phasenschicht durch eine aufgesetzte Heizquelle;

Fig. 6 Schnitt durch eine $Cr_2AlC$-Schicht auf einem Substrat, das auf eine Temperatur oberhalb der Diffusionstemperatur $T_{diff}$, jedoch unterhalb der Umwandlungstemperatur $T_{um}$ erhitzt wurde;

Fig. 7 Schnitt durch eine $Cr_2AlC$-Schicht auf einem Substrat, das auf eine Temperatur oberhalb der Umwandlungstemperatur $T_{um}$ erhitzt wurde;

Fig. 8 ortsabhängige Anteile an $Cr_2AlC$- beziehungsweise $Cr_7C_3$-Phasen in der Schutzschicht;

Fig. 9 Vergleich der Erosionsbeständigkeit von MAX-Phasen zu herkömmlichen Schutzschichten; und

Fig. 10 Funktionsprinzip eines Erosionskonzeptes mit einer adaptiven Schutzschicht bei einer Turbinenschaufel.

**Detaillierte Beschreibung der Erfindung**

Mit Hilfe der Erfindung lassen sich haft- und kratzfeste Schichten für den Verschleißschutz erzeugen. Eine mögliche Anwendung ist der Einsatz des Schichtsystems als Erosionsschutz auf Turbinenschaufeln. Wie einleitend bereits erläutert, ist die Erosionsrate niedrig für keramische Oberflächen bei kleinen Auftreffwinkeln und niedrig für metallische Oberflächen bei senkrechtem Auftreffen der Erosionspartikel. Die Konsequenz daraus ist ein neues Erosionsschutzkonzept mit einer Schicht, die örtlich angepasst wird.

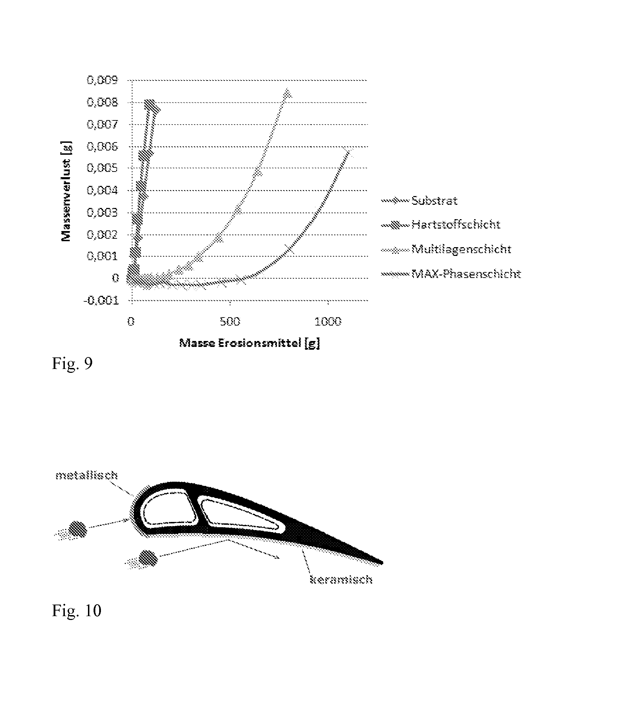

**Figur 10** zeigt das Funktionsprinzip einer solchen adaptiven Schicht am Beispiel einer Turbinenschaufel. Auf die Oberfläche der Turbinenschaufel wird - in noch näher erläuterter Art und Weise - eine Schutzschicht bestehend aus der MAX-Phase aufgetragen. Um die Haftung dieser Schicht zu erhöhen, wird eine erste Wärmebehandlung durchgeführt, in der sich eine Diffusionszone zwischen Substrat und aufgebrachter Schutzschicht ausbildet. Auf die Unterseite der Turbinenschaufel treffen üblicherweise Erosionspartikel mit geringem Aufprallwinkel auf. Daher wird in diesem Bereich eine zweite Wärmebehandlung durchgeführt, derart, dass die zunächst vorhandene metallische MAX-Phase thermisch in eine keramische Beschichtung gewandelt wird.

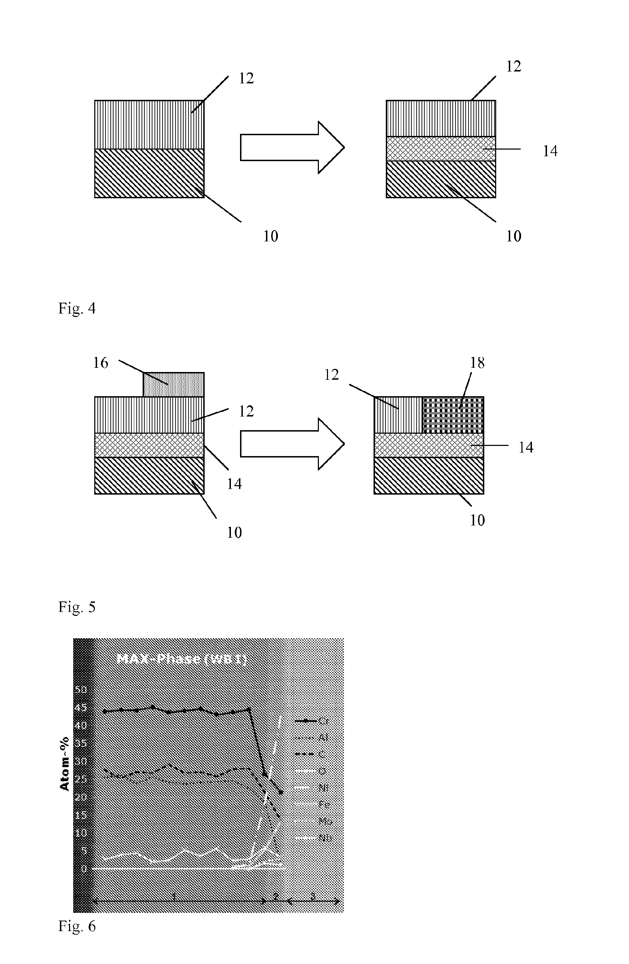

**Figur 4** zeigt stark schematisiert den Schritt c) (i) der ersten Wärmebehandlung eines mit einer MAX-Phase 12 beschichteten Werkstücks 10. Durch die Wärmebehandlung wird eine Diffusionsschicht 14 aus Teilen des Materials des Werkstücks 10 und der aufgetragenen MAX-Phase 12 erzeugt. Die Diffusionsschicht 14 verstärkt die Haftfestigkeit der Schutzschicht. Die Temperatur $T_1$ während dieser ersten Wärmebehandlung ist so gewählt, dass sich zwar eine Diffusionsschicht 14 ausbilden kann, die Temperatur jedoch noch unterhalb einer Umwandlungstemperatur $T_{um}$ liegt, bei der eine chemisch induzierte Wandlung der MAX-Phase 12 hin zu einem Produkt mit überwiegend keramischen Charakter stattfindet ($T_{diff} < T_1 < T_{um}$).

In einem sich anschließenden zweiten Behandlungsschritt (ii) wird das beschichtete Werkstück 10 mit Hilfe eines Heizelementes 16 lokal auf einen Teilbereich beschränkt auf eine Temperatur $T_2$ aufgeheizt (siehe **Figur 5**), die oberhalb der Temperatur $T_{um}$ liegt, ab der sich die metallische MAX-Phase in eine keramische Phase 18 wandelt ($T_{diff} < T_{um} < T_2$). Das Heizelement 16 kann beispielsweise ein Heizband, Laser oder ein Elektronenstrahl sein.

In einem konkreten Beispiel mit einer $Cr_2AlC$-MAX-Phasenschicht auf einem Nickelbasis-Substrat wurde im Zuge der ersten Wärmebehandlung das Schichtsystem für eine Stunde bei $T_1=700$ °C erhitzt. **Figur 6** zeigt, dass sich zwischen Schicht (Zone 1 in Figur 6) und Substrat (Zone 3 in Figur 6) die Diffusionszone 2 ausbildet, in der die chemischen Elemente der Schicht (Cr, Al, C) sowie des Substrates (Ni, Fe, Mo, Nb) zu finden sind.

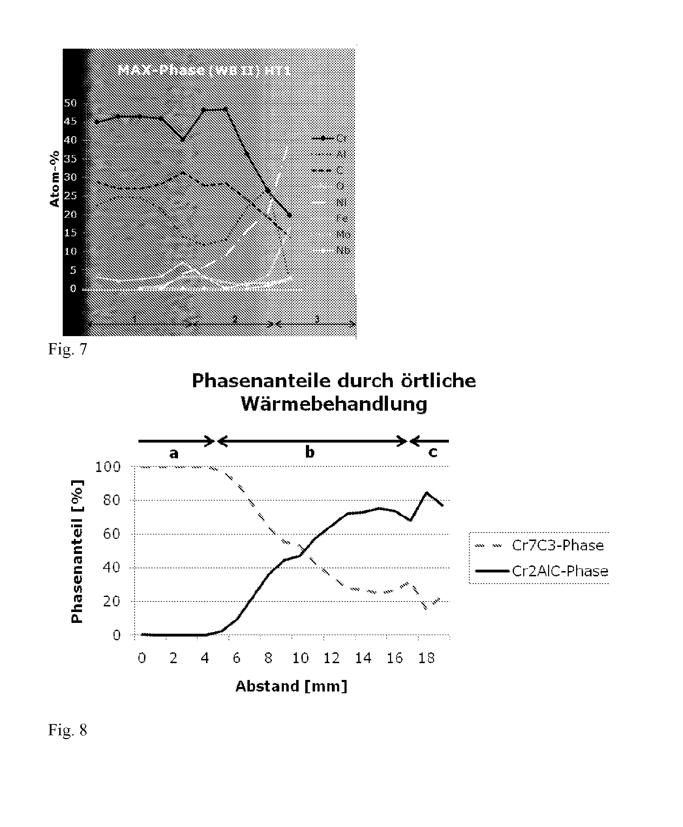

Anschließend wurde das beschichtete Substrat im Zuge der zweiten Wärmebehandlung für eine Stunde auf $T_2=840$ °C erhitzt, wobei die Phasenumwandlung stattfand. **Figur 7** zeigt eine deutlich vergrößerte Diffusionszone mit einer Entmischung der schichtbildenden chemischen Elemente über den Querschnitt der Schicht.

**Figur 8** illustriert die gemessenen Phasenanteile an $Cr_2AlC$- und $Cr_7C_3$ der erzeugten Schutzschicht in Abhängigkeit des Abstandes vom Heizelement bei $T_2$ und liefert damit den Nachweis für die generelle Machbarkeit.

Ein Vergleich der Erosionsbeständigkeit von MAX-Phasen zu herkömmlichen Schutzschichten ist Figur 9 zu entnehmen. Das Diagramm stellt den kontinuierlichen Masseverlust einer Probe durch Erosion über die Masse des Erosionsmittels bei 90° Einfallswinkel dar. Das Ergebnis in Figur 9 zeigt, dass das ungeschützte Substrat einen sehr hohen Masseverlust schon nach wenigen Gramm Erosionsmittel aufweist. Eine herkömmliche Hartstoffschicht versagt sehr rasch durch Abplatzen und verhält sich danach wie das Substrat. Deutlich mehr Erosionsmittel kann die Multilagenschicht aus $Cr_2AlC$

und $Cr_7C_3$ ertragen, bis ihr Masseverlust ansteigt. Der Widerstand gegen Erosion ist bei der MAX-Phasenschicht am stärksten, sodass erst nach 600 g Erosionsmittel ein nennenswerter Anstieg des Masseverlustes erfolgt.

Nachfolgend werden die Auftragung der MAX-Phase und die differenzierte thermische Behandlung des beschichteten Werkstücks anhand eines Beispiels näher erläutert.

**Ausführungsbeispiel**

Als Substratmaterial wurde die Nickelbasislegierung IN718 ausgewählt, die bis 1200er Körnung mit Schleifpapier geschliffen und im Ultraschallbad mit Ethanol gereinigt wurde. In der Beschichtungsanlage wurde danach für eine Dauer von 30 Minuten Mittelfrequenzlonenätzen zur Reinigung der Probenoberfläche eingesetzt. Als Schichtmaterial wurde eine 15 $\mu$m dicke $Cr_2AlC$-MAX-Phase mit konventionellem Gleichstrom-Magnetronsputtern von einem Pulvertarget bei einer Beschichtungstemperatur von 400 °C auf das Substrat abgeschieden. Anschließend erfolgte die erste Wärmebehandlung zur Ausbildung der Diffusionsschicht im Vakuum durch ein Temperaturprofil mit einer Stunde Aufheizen auf 700 °C, gefolgt von einer Stunde Haltezeit bei 700 °C und abschließend einer Stunde Abkühlzeit auf eine Temperatur von < 250 °C. Die zweite Wärmebehandlung zur partiellen Phasenumwandlung erfolgte analog der ersten Wärmebehandlung im Vakuum, jedoch wurde die Temperatur innerhalb eine Stunde bis auf 840 °C gebracht, wo sie für eine Stunde bei einer Temperatur von 840 °C gehalten wurde. Danach kühlten die Proben innerhalb einer Stunde auf < 300 °C ab.

Als Ergebnis konnte die Haftfestigkeit von 12,4 N (ohne Wärmebehandlung) auf 51,5 N (mit Wärmebehandlung) erhöht werden. Eine Konsequenz davon ist eine deutlich höhere Erosionsbeständigkeit, die mit deutlich geringeren Masseverlusten pro Masse Erosionsmittel in Verbindung steht. Dies zeigt die MAX-Phasenschicht im Vergleich zu anderen Schichtsystemen in Figur 9.

**Patentansprüche**

1.  Verfahren zur Herstellung einer haft- und kratzfesten Schutzschicht auf einem metallischen Werkstück, wobei die Schutzschicht ein örtlich angepasstes Erosionsverhalten besitzt und das Verfahren die folgenden Schritte umfasst:

     a) Bereitstellen eines metallischen Werkstücks aus einer Legierung auf Basis von Nickel, Eisen, Titan, Aluminium, Magnesium, Zink oder Kupfer;
     b) Beschichten des Werkstücks mit einer MAX-Phase der Formel (1)

$$M_{n+1}AX_n \qquad (1)$$

mit
M = Ti, Cr, V, Nb oder Mo;
A = Ga, Al, Ge oder Si;
X = C oder N; sowie
n = 1, 2 oder 3; und
c) örtlich differenzierte Wärmebehandlung des beschichteten Werkstücks, derart, dass

     i) das Werkstück in einem ersten Bereich auf eine Temperatur aufgeheizt wird, die oberhalb einer Temperatur $T_{diff}$ liegt, ab der sich eine Diffusionszone zwischen der MAX-Phase und der Legierung des Werkstücks ausbildet, die jedoch unterhalb einer Temperatur $T_{um}$ liegt, ab der sich die MAX-Phase in eine keramische Phase umwandelt; und
     ii) das Werkstück in einem zweiten Bereich auf eine Temperatur aufgeheizt wird, die oberhalb der Temperatur $T_{um}$ liegt, ab der sich die MAX-Phase in eine keramische Phase umwandelt.

2.  Verfahren nach Anspruch 1, bei dem die MAX-Phase ausgewählt ist aus der Gruppe umfassend $Ti_2GaC$, $Ti_2AlC$, $Ti_2AlN$, $Ti_3AlC_2$, $Ti_4AlN_3$, $Ti_2GeC$, $Ti_3GeC_2$, $Ti_3SiC_2$, $Cr_2GaC$, $Cr_2GaN$, $Cr_2AlC$, $Cr_2GeC$, $V_2GaC$, $V_2GaC$, $V_2AlC$, $V_2GeC$, $Nb_2GaC$, $Nb_2AlC$, $Mo_2GaC$ und $Mo_2GaC$.

3.  Verfahren nach Anspruch 1, bei dem die MAX-Phase ausgewählt ist aus der Gruppe umfassend $Ti_2AlC$, $Ti_2AlN$, $Ti_3GeC_2$, $Ti_3SiC_2$, $Cr_2AlC$, $V_2AlC$ und $Nb_2AlC$.

4.  Verfahren nach Anspruch 3, bei dem die MAX-Phase $Cr_2AlC$ ist.

5.  Verfahren nach einem der vorhergehenden Ansprüche, bei dem das metallische Werkstück aus einer Titan- oder Nickellegierung besteht.

6.  Verfahren nach einem der vorhergehenden Ansprüche, bei dem der Schritt b) des Beschichtens des Werkstücks mit einer MAX-Phase über ein PVD-Verfahren erfolgt.

7.  Metallisches Werkstück mit einer haft- und kratzfesten Schutzschicht, die ein örtlich angepasstes Erosionsverhalten besitzt, hergestellt nach einem Verfahren gemäß einem der Ansprüche 1 bis 6.

Fig. 1

Fig. 2

Fig. 3

Fig. 4

Fig. 5

Fig. 6

Fig. 7

## Phasenanteile durch örtliche Wärmebehandlung

Fig. 8

Fig. 9

Fig. 10

Europäisches
Patentamt

European
Patent Office

Office européen
des brevets

**EUROPÄISCHER RECHERCHENBERICHT**

Nummer der Anmeldung

EP 10 16 8291

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 5 683 226 A (CLARK EUGENE V [US] ET AL) 4. November 1997 (1997-11-04) * Ansprüche 1-9 * * Spalte 4, Zeile 17 - Zeile 37 * ----- | 7 | INV. C23C14/58 C23C14/06 F01D5/28 |
| A | WO 03/046247 A1 (ABB AB [SE]; ISBERG PETER [SE]; PALMQUIST JENS-PETTER [SE]; JANSSON UL) 5. Juni 2003 (2003-06-05) * das ganze Dokument * ----- | 1-7 | |
| A | EP 0 264 654 A1 (UNION CARBIDE CORP [US]) 27. April 1988 (1988-04-27) * das ganze Dokument * ----- | 1-7 | |

**RECHERCHIERTE SACHGEBIETE (IPC)**

C23C
F01D

Der vorliegende Recherchenbericht wurde für alle Patentansprüche erstellt

| Recherchenort | Abschlußdatum der Recherche | Prüfer |
|---|---|---|
| Den Haag | 17. Dezember 2010 | Rischard, Marc |

**EP 2 405 029 A1**

**ANHANG ZUM EUROPÄISCHEN RECHERCHENBERICHT**
**ÜBER DIE EUROPÄISCHE PATENTANMELDUNG NR.**

EP 10 16 8291

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

17-12-2010

| Im Recherchenbericht angeführtes Patentdokument | | Datum der Veröffentlichung | Mitglied(er) der Patentfamilie | | Datum der Veröffentlichung |
|---|---|---|---|---|---|
| US 5683226 | A | 04-11-1997 | KEINE | | |
| WO 03046247 | A1 | 05-06-2003 | AT | 378441 T | 15-11-2007 |
| | | | AU | 2002365543 A1 | 10-06-2003 |
| | | | CN | 1617945 A | 18-05-2005 |
| | | | DE | 60223587 T2 | 18-09-2008 |
| | | | EP | 1448804 A1 | 25-08-2004 |
| | | | ES | 2297034 T3 | 01-05-2008 |
| | | | US | 2005076825 A1 | 14-04-2005 |
| EP 0264654 | A1 | 27-04-1988 | CA | 1302807 C | 09-06-1992 |
| | | | DE | 3762888 D1 | 28-06-1990 |
| | | | JP | 1871833 C | 06-09-1994 |
| | | | JP | 5080549 B | 09-11-1993 |
| | | | JP | 63179059 A | 23-07-1988 |

EPO FORM P0461

Für nähere Einzelheiten zu diesem Anhang : siehe Amtsblatt des Europäischen Patentamts, Nr.12/82

11